# EUROPÄISCHE PATENTSCHRIFT

(11) **EP 1 321 885 B1**
(45) Veröffentlichungstag und Bekanntmachung des Hinweises auf die Patenterteilung: **21.06.2006**
(21) Anmeldenummer: 02027428.8
(22) Anmeldetag: 09.12.2002
(51) Int. Cl.: G06K 13/08

(54) **Elektronisches Gerät**
Electronic device
Appareil électronique

(30) Priorität: 19.12.2001 DE 20120564 U
(43) Veröffentlichungstag der Anmeldung: 25.06.2003
(73) Patentinhaber: SIEMENS AKTIENGESELLSCHAFT, 80333 München (DE)
(72) Erfinder: Kurrer, Siegfried, 90449 Nürnberg (DE)

(56) Entgegenhaltungen:
- EP-A- 1 060 456
- US-A- 5 179 504

## Beschreibung

Die Erfindung betrifft ein elektronisches Gerät, welches zumindest eine Einrichtung zur datentechnischen Kontaktierung von mindestens einer Speicherkarte aufweist.

Es sind eine Vielzahl von Geräten im Einsatz, die Daten mit Hilfe von Speicherkarten austauschen können. Hierzu weisen diese Geräte zumindest eine Einrichtung zur datentechnischen Kontaktierung mit einer Speicherkarte auf. Hierüber können Daten von einer Speicherkarte gelesen bzw. darauf geschrieben werden. Darüber hinaus weisen Geräte dieser Art in der Regel eine Fülle weiterer Betriebsmittel auf, z.B. um gelesene Daten entsprechend weiterverarbeiten und anzeigen zu können.

Speicherkarten sind einerseits leicht handhabbar, so dass diese auf einfache Weise in eine Einrichtung zur datentechnischen Kontaktierung eines Gerätes eingebracht werden können. Dabei muß aber sichergestellt sein, dass diese darin herausfallsicher gehalten werden, damit ein störungsfreier Datenaustausch zwischen Speicherkarte und elektronischem Gerät möglich ist.

In der Schrift EP 1 060 456 B1 wird eine Vorrichtung zur datentechnischen Kontaktierung einer Speicherkarte vorgestellt. Allerdings kann die Vorrichtung vergleichsweise leicht beim Einschieben verkanten und ist vor äußeren mechanischen Einflüssen kaum geschützt, da sie auch im eingeschobenen Zustand etwas hervorsteht. Daher funktioniert die in EP 1 060 456 B1 angegebene Vorrichtung vergleichsweise unsicher.

Der Erfindung liegt demnach die Aufgabe zu Grunde, ein elektronisches Gerät so weiterzubilden, dass eine herausfallsichere Halterung einer Speicherkarte in einer entsprechenden Kontaktierungseinrichtung mit Sicherheit gewährleistet ist.

Diese Aufgabe wird erfindungsgemäß dadurch gelöst, dass die Haltemittel eine Aufnahmemulde zum Einlegen des Sicherungsteils aufweisen, welche in das Gehäuse eingelassen ist.

Mit einer derartigen Anordnung ist es einerseits möglich, den Aufnahmeschlitz der Kontaktierungseinrichtung abzudecken, auch wenn sich keine Speicherkarte in der Kontaktierungseinrichtung befinden sollte. Hiermit kann die Kontaktierungseinrichtung gegen Umwelteinflüsse und auch unbefugte Manipulationen geschützt werden. Andererseits ermöglicht die erfindungsgemäße Anordnung eine insbesondere gegenüber Herausfallen und unbefugten Manipulationen geschützte Halterung einer in einem Aufnahmeschlitz der Kontaktierungseinrichtung befindlichen Speicherkarte.

Weitere vorteilhafte Ausführungsformen der Erfindung sind in den Unteransprüchen angegeben.

Im Weiteren wird ein bevorzugtes Ausführungsbeispiel der Erfindung mit Bezugnahme auf die Zeichnungen näher erläutert.

Es zeigen:
- Fig. 1: eine bevorzugte Ausführungsform eines elektronischen Gerätes gemäß der Erfindung in Frontansicht, wobei das blechartige Sicherungsteil mit dem Gehäuse noch nicht in einer Wirkverbindung steht, und
- Fig. 2: das elektronische Gerät gemäß Figur 1, wobei das blechartige Sicherungsteil in erfindungsgemäßer Weise unter zumindest teilweiser Abdeckung des Aufnahmeschlitzes fest am Gehäuse positioniert ist.

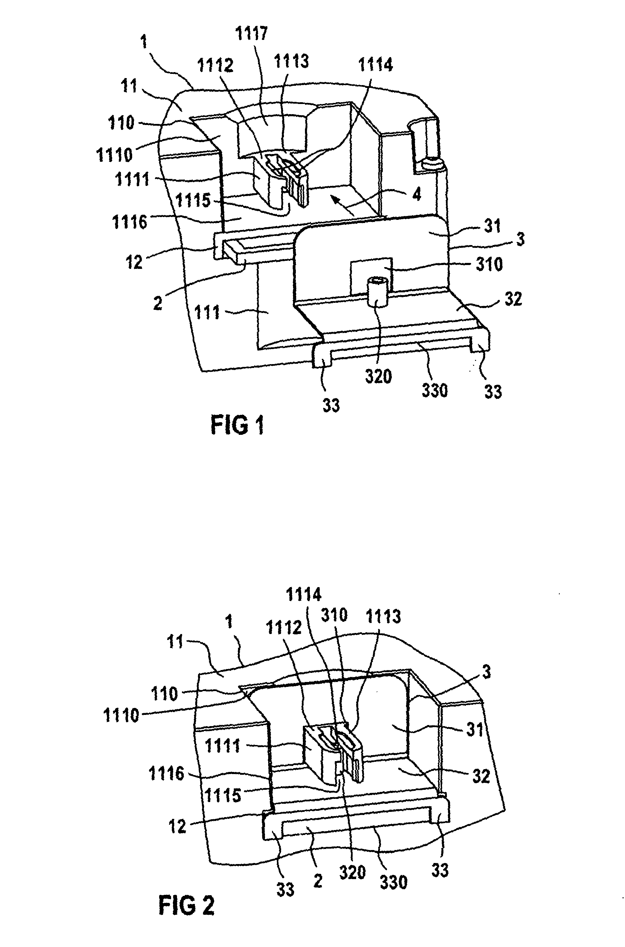

In Figur 1 ist eine vorteilhafte Ausführungsform eines gemäß der Erfindung gestalteten elektronischen Geräts 1 teilweise dargestellt. Der abgebildete Ausschnitt zeigt den Bereich des Gehäuses 11 des elektronischen Geräts 1, an dem einerseits der Aufnahmeschlitz 12 für eine Speicherkarte 2 mit einer im Inneren dahinter liegenden datentechnischen Kontakteinrichtung angeordnet sind. Der dargestellte Bereich des Gehäuses 11 weist andererseits die zur Fixierung des blechartigen Sicherungsteils 3 vorgesehenen Haltemittel auf. Eine besonders vorteilhafte Ausführung dieser Haltemittel, womit das Sicherungsteil 3 unter zumindest teilweiser Abdeckung des Aufnahmeschlitzes 12 am Gehäuse 11 positionierbar ist, wird nachfolgend am Beispiel der Figuren 1 und 2 näher erläutert.

Vorteilhaft weisen die Haltemittel des elektronischen Geräts 1 eine Aufnahmemulde 110 zum Einlegen des Sicherungsteils 3 auf, welche in das Gehäuse 11 eingelassen ist. Vorteilhaft ist die Aufnahmemulde 110 in unmittelbarer räumlicher Nähe zum Aufnahmeschlitz 12 am Gehäuse 11 angeordnet. Im Beispiel der Figur 1 ist die Aufnahmemulde 110 direkt über dem Aufnahmeschlitz 12 liegend angeordnet.

Das Sicherungsteil 3 weist im Beispiel der Figuren 1 und 2 eine derartige Form auf, dass es in die Aufnahmemulde 110 einlegbar ist. Dabei zeigt Figur 1 eine Zustand, in dem das blechartige Sicherungsteil mit dem Gehäuse noch nicht in einer Wirkverbindung steht. Demgegenüber ist in Figur 2 das Sicherungsteil vollständig in die Aufnahmemulde 110 der Haltemittel des Gehäuses 11 eingelegt und bewirkt die Sicherung einer Speicherkarte gegen versehentliches Herausfallen.

In Figur 1 ist die Einschubrichtung des Sicherungsteiles 3 in die Aufnahmemulde 110 durch einen Pfeil 4 gekennzeichnet. Das Sicherungsteil 3 weist vorteilhaft die Form eines Winkelbleches mit einem Bodenteil 32 und einem davon abgewinkelten Rückenteil 31 auf. Diese kommen im eingeschobenen Zustand des Sicherungsteiles 3 auf einer Rückwand 1110 und einem Boden 1116 der Aufnahmemulde 110 zu liegen. Der vollständig in die Aufnahmemulde 110 des Gehäuses 1 eingeschobene Zustand des Sicherungsteiles 3 ist im Beispiel der Figur 2 dargestellt. Zum Zwecke einer zumindest teilweisen Abdeckung des Aufnahmeschlitzes 12 z.B. in einem Eckbereich weist das Sicherungsteil 3 vorteilhaft zumindest eine Haltenase 33 auf. Bei der in den Figuren 1 und 2 dargestellten, vorteilhaften Ausführungsform der Erfindung sind an der vorderen Stirnseite des Bodenteiles 32 des Sicherungsteiles 3 beidseitig zwei Haltenasen 33 abgewinkelt. Diese liegen im eingeschobenen Zustand des Sicherungsteiles 3, wie in Figur 2 dargestellt, beidseitig auf der Stirnseite einer eingeschobenen Speicherkarte 2 auf. Hierdurch wird die Speicherkarte 2 fest im Aufnahmeschlitz 12 gehalten und ein versehentliches Herausrutschen verhindert. Der zwischen den Haltenasen 33 liegende freie Raum kann als eine zusätzliche Durchgriffsöffnung 330 dienen. Hierdurch können zusätzliche, in den Figuren 1, 2 nicht näher dargestellte und mit der Speicherkarte 2 insbesondere an deren Stirnseite verbundene Datenbuskabel herausgeführt werden.

Vorteilhaft sind die Größe der Aufnahmemulde 110 im Gehäuse 11 und insbesondere die Breite des blechartigen Sicherungsteiles 3 so aufeinander abgestimmt, dass nach Einlage des Sicherungsteiles in die Aufnahmemulde eine Verklemmung zwischen beiden Teilen eintritt. Hierdurch kann in der Praxis eine für normale Anwendungsfälle ausreichende Fixierung des Sicherungsteiles 3 am Gehäuse 11 und damit Halterung einer eingeschobenen Speicherkarte 12 erreicht werden.

Vorteilhaft können auf der Gehäuseaußenseite Fingermulden 111, 1117 vorhanden sein. Über die Fingermulde 1117 ist eine manuelle Entnahme des Sicherungsteiles 3 aus der Aufnahmemulde 110 möglich, während die Fingermulde 111 eine Entnahme einer Speicherkarte 2 aus dem Aufnahmeschlitz 12 ermöglicht.

Falls das Gehäuse einer besonderen Rüttelbelastung ausgesetzt sein sollte, können die Haltemittel zusätzliche zur Aufnahmemulde weitere Elemente aufweisen, um eine besonders sichere Fixierung des Sicherungsteils am Gehäuse zu gewährleisten. Eine solche Ausgestaltung ist bei der in den Figuren dargestellten Ausführungsform der Erfindung bereits enthalten.

Dabei weisen die Haltemittel zusätzlich eine vorspringende Befestigungsnase 1111 zur Fixierung des Sicherungsteils 3 auf, welche in die Aufnahmemulde 110 hineinragt. Vorteilhaft ist die Befestigungsnase 1111 annähernd mittig an einer Rückwand 1110 der Aufnahmemulde 110 angebracht und springt davon hervor. Bei einer weiteren, besonders vorteilhaften, in den Figuren 1 und 2 ebenfalls bereits dargestellten Ausführung weist die Befestigungsnase 1111 zwei Flügel 1112,1113 auf, welche einen dazwischen liegenden vertikalen Aufnahmeschlitz 1115 begrenzen. Die Befestigungsnase 1111 ist vorteilhaft nicht mit dem Boden 1116 der Aufnahmemulde 110 verbunden.

Um einen Eingriff der Befestigungsnase 1111 auf das Sicherungsteil 3 zu ermöglichen, weist dessen Rückenteil 31 vorteilhaft eine Durchgriffsöffnung 310 auf. Bei einem Einschub des Sicherungsteiles 3 in die Aufnahmemulde 110 in Einschubrichtung 4 tritt die Befestigungsnase 1111 in die Durchgriffsöffnung 310 ein. Mit Hilfe von weiteren Befestigungselementen kann nun eine besonders robuste mechanische Verbindung zwischen Sicherungsteil 3 und Befestigungsnase 1111 hergestellt werden.

Als weitere Befestigungselemente können die Haltemittel vorteilhaft ein bevorzugt bolzenförmiges Aufnahmeelement 320 aufweisen. Dieses ist vorteilhaft auf dem Bodenteil 32 des Sicherungsteiles 3 angebracht. Bei einem Einschub des Sicherungsteiles 3 wird das Aufnahmeelement 320 von der vorspringenden Befestigungsnase 1111 der Haltemittel erfaßt. Dabei taucht das Aufnahmeelement 320 vorteilhaft in den Aufnahmeschlitz 1116 der vorspringenden Befestigungsnase 1111 ein und wird dort mittels mechanischer Verklemmung zwischen den beiden Flügeln 1112 und 1113 gehalten.

Das Aufnahmeelement 320 kann vorteilhaft als eine Gewindebuchse ausgeführt sein. Ein zusätzliches Befestigungselement, insbesondere eine Befestigungsschraube, ist dann in das Aufnahmeelement 320 einschraubbar und bewirkt eine Verklemmung mit der vorspringenden Befestigungsnase 1111 insbesondere über die Auflageflächen auf der Oberseite 1114 der Flügel 1112 und 1113.

## Patentansprüche

1. Elektronisches Gerät (1), das zumindest eine Einrichtung zur datentechnischen Kontaktierung von mindestens einer Speicherkarte (2) aufweist, mit einem blechartigen Sicherungsteil (3) und einem Gehäuse (11), das einen Aufnahmeschlitz (12) zur Aufnahme einer Speicherkarte (2) für die Einrichtung zur datentechnischen Kontaktierung aufweist, und Haltemittel (110, 1111), womit das Sicherungsteil (3) unter zumindest teilweiser Abdeckung des Aufnahmeschlitzes (12) am Gehäuse (11) positionierbar ist, **dadurch gekennzeichnet, dass** die Haltemittel eine Aufnahmemulde (110) zum Einlegen des Sicherungsteils (3) aufweisen, welche in das Gehäuse (11) eingelassen ist.

2. Elektronisches Gerät (1) nach Anspruch 1, wobei die Aufnahmemulde (110) in unmittelbarer räumlicher Nähe zum Aufnahmeschlitz (12) am Gehäuse (11) angeordnet ist.

3. Elektronisches Gerät (1) nach Anspruch 1 oder 2, wobei die Haltemittel eine vorspringende Befestigungsnase (1111, 1112,1113,1114,1115) für das Sicherungsteil (3) aufweisen, welche in die Aufnahmemulde (110) hineinragt.

4. Elektronisches Gerät (1) nach Anspruch 3, wobei die Befestigungsnase (1111,1112,1113,1114,1115) der Haltemittel an einer Rückwand (1110) der Aufnahmemulde(110) angeordnet ist.

5. Elektronisches Gerät (1) nach einem der Ansprüche 1 bis 4, wobei das Sicherungsteil (3) in die Aufnahmemulde (110) einlegbar ausgeführt ist.

6. Elektronisches Gerät (1) nach einem der vorangegangenen Ansprüche, wobei das Sicherungsteil (3) zumindest eine Haltenase (33) aufweist, welche den Aufnahmeschlitz (12) in einem Eckbereich teilweise abdeckt.

7. Elektronisches Gerät (1) nach Anspruch 6, wobei das Sicherungsteil (3) ein Bodenteil (32) aufweist, von dem die zumindest eine Haltenase (33) abgewinkelt ist.

8. Elektronisches Gerät (1) nach einem der Ansprüche 7, wobei das Sicherungsteil (3) als ein Winkelblech ausgeführt ist, das ein vom Bodenteil (32) abgewinkeltes Rückenteil (31) aufweist.

9. Elektronisches Gerät (1) nach Anspruch 8, wobei das Rückenteil (31) des Sicherungsteiles (3) eine Durchgriffsöffnung (310) für die vorspringende Befestigungsnase (1111) der Haltemittel aufweist.

10. Elektronisches Gerät (1) nach Anspruch 8 oder 9, wobei das Bodenteil (32) des Sicherungsteiles (3) ein Aufnahmeelement (320) zum Eingriff der Haltemittel (1111) des Gehäuses (11) trägt.

11. Elektronisches Gerät (1) nach Anspruch 10, wobei das Aufnahmeelement (320) des Sicherungsteiles (3) eine Gewindebuchse (320) ist.

12. Elektronisches Gerät (1) nach einem der Ansprüche 3 bis 11, wobei die vorspringende Befestigungsnase (1111) zwei Flügel (1112,1113) mit einem dazwischen liegenden Aufnahmeschlitz (1116) aufweist.

13. Elektronisches Gerät (1) nach Anspruch 10 und 12, wobei das Aufnahmeelement (320) bei einer Positionierung des Sicherungsteiles (3) am Gehäuse (11) in den Aufnahmeschlitz (1116) der vorspringenden Befestigungsnase (1111) eintaucht.

14. Elektronisches Gerät (1) nach Anspruch 13, mit einem zusätzlichen Befestigungselement, insbesondere einer Befestigungsschraube, welche mit dem Aufnahmeelement (320) verbindbar und mit der vorspringenden Befestigungsnase (1111) verklemmbar ist.

## Claims

1. Electronic device (1) comprising at least one arrangement for data-related contacting with at least one memory card (2), having a metal plate-like securing element (3) and a housing (11), which has an insertion slot (12) for accommodating a memory card (2) for the data-related contacting arrangement, and retaining means (110, 1111) whereby the securing element (3) may be positioned so that it at least partially covers the insertion slot (12) in the housing (11), **characterized in that** the retaining means has a receiving recess (110) for inserting the securing element (3), said receiving recess being formed in the housing (11).

2. Electronic device (1) according to Claim 1, wherein the receiving recess (110) is disposed in the direct vicinity of the insertion slot (12) in the housing (11).

3. Electronic device (1) according to Claim 1 or 2, wherein the retaining means have a protruding fastening lug (1111, 1112,1113,1114,1115) for the securing element (3), said fastening lug extending into the receiving recess (110).

4. Electronic device (1) according to Claim 3, wherein the fastening lug (1111,1112,1113,1114,1115) of the retaining means is disposed on a rear wall (1110) of the receiving recess (110).

5. Electronic device (1) according to one of claims 1 to 4, wherein the securing element (3) insertable into the receiving recess (110).

6. Electronic device (1) according to one of the preceding claims, wherein the securing element (3) comprises at least one retaining lug (33), which partially covers the insertion slot (12) at a corner area.

7. Electronic device (1) according to Claim 6, wherein the securing element (3) comprises a bottom part (32) from which there is bent at least one retaining lug (33).

8. Electronic device (1) according to one of Claims 7, wherein the securing element (3) is designed as an angle plate that has a rear section (31) angled away from the floor section (32).

9. Electronic device (1) according to Claim 8, wherein the rear part (31) of the security element (3) has an access opening (310) for the protruding fastening lug (1111) of the retaining means.

10. Electronic device (1) according to Claim 8 or 9, wherein the bottom part (32) of the securing element (3) carrier a receiving element (320) for insertion of the retaining means (1111) of the housing (11).

11. Electronic device (1) according to Claim 10, wherein the receiving element (320) of the securing element (3) is a threaded connector (320).

12. Electronic device (1) according to one of claims 3 to 11, wherein the protruding fastening lug (1111) comprises two wings (1112,1113) with an insertion slot (1116) lying between them.

13. Electronic device (1) according to Claims 10 and 12, wherein the receiving element (320) enters into the insertion slot (1116) of the protruding fastening lug (1111) upon a positioning of the securing element (3) at the housing (11).

14. Electronic device (1) according to Claim 13, having an additional fastening element, in particular a fastening screw, connectable with the receiving element (320) and engageable with the protruding fastening lug (1111).

## Revendications

1. Appareil (1) électronique qui a au moins un dispositif pour la mise en contact, du point de vue de la technique des données, d'au moins une carte (2) de mémoire, comprenant une partie (3) de sécurité du type en tôle et un boîtier (11) qui a une fente (12) de réception d'une carte (2) de mémoire pour le dispositif de mise en contact du point de vue de la technique des données et des moyens (110, 1111) de maintien, par lesquels la partie (3) de sécurité peut être mise en position sur le boîtier (11) en recouvrant au moins en partie la fente (12) de réception, **caractérisé en ce que** les moyens de maintien ont, enchâssée dans le boîtier (11), une cuvette (110) de réception pour mettre la partie (3) de sécurité.

2. Appareil (1) électronique suivant la revendication 1, dans lequel la cuvette (110) de réception est disposée sur le boîtier (11) à proximité immédiate de la fente (12) de réception.

3. Appareil (1) électronique suivant la revendication 1 ou 2, dans lequel les moyens de maintien ont un bec (1111, 1112, 1113, 1114, 1115) de fixation en saillie de la partie (3) de sécurité, qui pénètre dans la cuvette (110) de réception.

4. Appareil (1) électronique suivant la revendication 3, dans lequel le bec (1111, 1112, 1113, 1114, 1115) de fixation des moyens de maintien est disposé sur une paroi (1110) arrière de la cuvette (110) de réception.

5. Appareil (1) électronique suivant l'une des revendications 1 à 4, dans lequel la partie (3) de sécurité peut être mise dans la cuvette (110) de réception.

6. Appareil (1) électronique suivant l'une des revendications précédentes, dans lequel la partie (3) de sécurité a au moins un bec (33) de maintien, qui recouvre en partie la fente (12) de réception dans une zone de coin.

7. Appareil (1) électronique suivant la revendication 6, dans lequel la partie (3) de sécurité a une partie (32) de fond, à partir de laquelle le au moins un bec (33) de maintien est coudé.

8. Appareil (1) électronique suivant la revendication 7, dans lequel la partie (3) de sécurité est réalisée sous la forme d'une tôle coudée qui a une partie (31) arrière coudée à partir de la partie (32) de fond.

9. Appareil (1) électronique suivant la revendication 8, dans lequel la partie (31) arrière de la partie (3) de sécurité a une ouverture (310) d'accrochage du bec (1111) de fixation en saillie des moyens de maintien.

10. Appareil (1) électronique suivant la revendication 8 ou 9, dans lequel la partie (32) de fond de la partie (3) de sécurité porte un élément (320) de réception destiné à pénétrer dans les moyens (1111) de maintien du boîtier (11).

11. Appareil (1) électronique suivant la revendication 10, dans lequel l'élément (320) de réception de la partie (3) de sécurité est une douille (320) taraudée.

12. Appareil (1) électronique suivant l'une des revendications 3 à 11, dans lequel le bec (1111) de fixation en saillie a deux ailes (1112, 1113) avec une fente (1116) de réception entre elles.

13. Appareil (1) électronique suivant la revendication 10 et 12, dans lequel l'élément (320) de réception pénètre, pour mettre en position la partie (3) de sécurité sur le boîtier (11), dans la fente (1116) de réception du bec (1111) de fixation en saillie.

14. Appareil (1) électronique suivant la revendication 13, comprenant un élément de fixation supplémentaire, notamment une vis de fixation, qui peut être relié à l'élément (320) de réception et qui peut être serré par le bec (1111) de fixation en saillie.
